# EUROPÄISCHE PATENTSCHRIFT

(11) **EP 1 192 551 B1**
(45) Veröffentlichungstag und Bekanntmachung des Hinweises auf die Patenterteilung: **08.01.2003**
(21) Anmeldenummer: 00949062.4
(22) Anmeldetag: 26.05.2000
(51) Int. Cl.: G06F 13/40, H04B 3/54

(54) **INTERFACE ZUM ANKOPPELN EINES BUSTEILNEHMERS AN DIE BUSLEITUNG EINES BUSSYSTEMS**
INTERFACE FOR COUPLING A BUS NODE TO THE BUS LINE OF A BUS SYSTEM
INTERFACE POUR COUPLER UN NOEUD DE BUS A LA LIGNE BUS D'UN SYSTEME BUS

(30) Priorität: 08.06.1999 DE 19926095
(43) Veröffentlichungstag der Anmeldung: 03.04.2002
(73) Patentinhaber: SIEMENS AKTIENGESELLSCHAFT, 80333 München (DE)
(72) Erfinder: FICHTNER, Norbert, D-84069 Schierling (DE); MUNZ, Dieter, D-91315 Höchstadt (DE)
(86) Internationale Anmeldenummer: DE0001712
(87) Internationale Veröffentlichungsnummer: WO00075794

(56) Entgegenhaltungen:
- DE-C- 19 639 635
- DE-U- 29 900 129
- US-A- 5 838 073
- PATENT ABSTRACTS OF JAPAN vol. 013, no. 488 (P-954), 7. November 1989 (1989-11-07) & JP 01 193953 A (PFU LTD), 3. August 1989 (1989-08-03)

## Beschreibung

Die Erfindung bezieht sich auf ein Interface zum Ankoppeln eines Busteilnehmers an die Busleitung eines Bussystems, insbesondere an das Bussystem EIB der European Installation Bus Association EIBA.

Das Bussystem EIB ist ein Zweidraht-Bussystem, bei dem die Spannungsversorgung der jeweils über ein Interface an das Bussystem angeschlossenen Busteilnehmer und die Datenübertragung zwischen diesen auf einem Leiterpaar zusammengefasst sind. Bei dieser Art von Bussystemen ist die Stromentnahme pro Busteilnehmer begrenzt auf beispielsweise 10mA. Eine solche begrenzte Stromentnahme ist jedoch nicht in allen Anwendungsfällen für alle Busteilnehmer ausreichend, so dass es erforderlich sein kann, Busteilnehmer mit einem höheren Strombedarf mit einer externen Spannung zu versorgen. Eine solche zusätzliche, busunabhängige externe Spannungsversorgung kann auch zur Entlastung der Spannungsversorgung des EIB von Vorteil sein.

Dabei ergibt sich die Situation, dass zwar das Interface, beispielsweise ein TPUART-IC, aus dem EIB selbst versorgt wird, der über dieses Interface an das Bussystem angeschlossene Busteilnehmer jedoch von einer externen, davon unabhängigen Spannungsversorgung gespeist wird.

Das beim EIB verwendete bekannte Interface erzeugt ein Steuersignal (Resetsignal) für den Busteilnehmer, mit dem unter anderem der Datenaustausch erst dann freigegeben wird, wenn die Versorgungsspannung des Busteilnehmers einen vorgegebenen Wert erreicht und der Busteilnehmer außerdem ausreichend Zeit für einen korrekten Hochlauf erhalten hat. Bei fehlender oder nicht ausreichender Busspannung gibt das Interface einen Wert für ein binäres Steuersignal aus, beispielsweise Low (= Reset aktiv), mit dem sichergestellt ist, dass ein Datenaustausch nicht stattfinden kann. Erst wenn sowohl die Versorgungsspannung des Interfaces als auch die vom Interface an den Busteilnehmer weitergegebene Busspannung einen vorgegebenen Wert erreicht hat, wird das Steuersignal auf einen anderen Wert gesetzt, beispielsweise High (= Reset inaktiv), und ein Datenaustausch ermöglicht.

Bei einem über ein externes Netzgerät versorgten Busteilnehmer kann nun eine Betriebssituation eintreten, bei der einerseits die Busspannung noch nicht in ausreichender Höhe anliegt, andererseits jedoch die externe Spannungsversorgung für den Busteilnehmer bereits vorhanden ist, so dass der Busteilnehmer aktiv ist, das Interface selbst jedoch noch nicht mit einer zu seinem Betrieb erforderlichen ausreichenden Versorgungsspannung versorgt ist. In diesem Fall würde ein Sendeversuch des Busteilnehmers zu einer Fehlermeldung führen.

Aus der JP 01 193 953 A ist ein System for detecting abnormality of bus und aus der DE 196 39 635 C ist eine CMOS-Bus-Treiberschaltung bekannt.

Der Erfindung liegt nun die Aufgabe zugrunde, ein Interface zum Ankoppeln eines Busteilnehmers an die Busleitung eines Bussystems anzugeben, mit dem der vorstehend genannte fehlerhafte Betriebszustand vermieden ist.

Die genannte Aufgabe wird gemäß der Erfindung gelöst mit einem Interface mit den Merkmalen des Patentanspruches 1. Das erfindungsgemäße Interface enthält einen Eingang für eine von einer busunabhängigen Spannungsquelle bereitgestellte externe Versorgungsspannung und eine Überwachungsschaltung zum Vergleichen einer aus der Busspannung abgeleiteten internen Versorgungsspannung mit der externen Versorgungsspannung und zum Generieren eines Ausgangssteuersignals für den Busteilnehmer in Abhängigkeit vom Vergleichsergebnis. Durch diese Maßnahme ist sichergestellt, dass der Busteilnehmer erst dann freigeschaltet wird, wenn auch das Interface sich in einem ordnungsgemäßen Betriebszustand befindet.

In einer bevorzugten Ausgestaltung der Erfindung ist das Ausgangssteuersignal ein binäres Signal, dessen Wert durch das Vorzeichen der Differenz zwischen einer aus der internen Versorgungsspannung und der externen Versorgungsspannung jeweils abgeleiteten internen bzw. externen Referenzspannung bestimmt ist. Ein solches erfindungsgemäßes Interface ist insbesondere für die Verwendung in einem Bussystem vorgesehen, das zumindest einen Busteilnehmer enthält, der von einer busunabhängigen Spannungsquelle mit einer externen Versorgungsspannung versorgt wird.

Das erfindungsgemäße Interface kann auch zum Ankoppeln eines von der Busspannung versorgten Busteilnehmers verwendet werden. Hierzu ist es in einer vorteilhaften Ausgestaltung der Erfindung nur erforderlich, den Eingang der externen Versorgungsspannung mit einem Ausgang für die interne Versorgungsspannung kurzzuschließen.

Zur weiteren Erläuterung der Erfindung wird auf das Ausführungsbeispiel der Zeichnung verwiesen. Es zeigen:
- FIG 1: ein Interface gemäß der Erfindung mit einem daran angeschlossenen Busteilnehmer in einem Blockschaltbild,
- FIG 2: eine vorteilhafte Ausgestaltung einer Überwachungsschaltung für ein Interface gemäß der Erfindung.

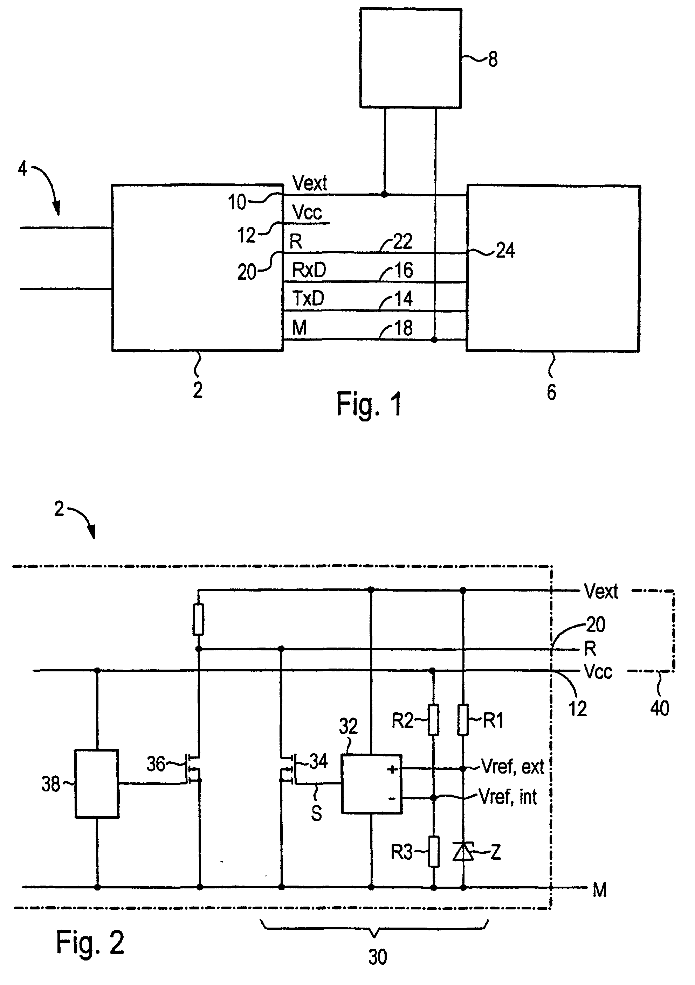

Gemäß FIG 1 ist ein Interface 2, beispielsweise ein TPUART-IC, an ein Bussystem 4, im Beispiel ein Zweidraht-Bussystem, insbesondere ein EIB, angeschlossen. Über das Interface 2 ist ein Busteilnehmer 6 an das Bussystem 4 angeschlossen, der die für diesen Busteilnehmer 6 spezifische Anwenderelektronik enthält.

Der Busteilnehmer 6 wird von einer busunabhängigen Spannungsquelle 8 mit einer externen Versorgungsspannung Vext versorgt. Die Spannungsquelle 8 ist busunabhängig in dem Sinne, dass die von ihr erzeugte Versorgungsspannung Vext unabhängig von der Busspannung ist und das Bussystem 4 nicht belastet.

Die busunabhängige Spannungsquelle 8 ist an einem Spannungseingang 10 des Interface 2 angeschlossen. Das Interface 2 stellt an einem Spannungsausgang 12 eine intern aus der Busspannung des Bussystems 4 erzeugte interne Versorgungsspannung Vcc zur Verfügung, die zur Spannungsversorgung eines Busteilnehmers vorgesehen ist, der nicht an eine busunabhängige Spannungsquelle 8 angeschlossen ist. Im Ausführungsbeispiel ist dieser Spannungsausgang 12 nicht an den Busteilnehmer 6 angeschlossen, da dieser über die externe Spannungsquelle 8 versorgt wird. Der Austausch von Daten TxD und RxD zwischen dem Bussystem 4 und dem Busteilnehmer 6 findet über Sende- und Empfangsleitungen 14 bzw. 16 statt. Über eine Masseleitung 18 werden das Interface 2 und der Busteilnehmer 6 auf gleiches Bezugspotential M gelegt.

An einem Steuerausgang 20 des Interface 2 steht ein Ausgangssteuersignal R an, das über eine Steuerleitung 22 an einen Spannungseingang 24 des Busteilnehmers 6 weitergeleitet wird. Dieses Ausgangssteuersignal R ist ein binäres Signal mit zwei möglichen Zustandswerten, das den Busteilnehmer 6 zum Empfang und zur Übertragung von Daten freischaltet.

Gemäß FIG 2 enthält das Interface 2 eine Überwachungsschaltung mit einem Komparator 32, mit dem ein Vergleich der aus der Busspannung abgeleiteten internen Versorgungsspannung Vcc mit der externen Versorgungsspannung Vext vorgenommen wird. Die externe Versorgungsspannung Vext ist über einen Schutzwiderstand R1 und eine dazu in Reihe geschaltete Zenerdiode Z an Masse M angeschlossen. Der Pluseingang des Komparators 32 ist zwischen die Zenerdiode Z und den Schutzwiderstand R1 geschaltet.

Sobald die externe Versorgungsspannung Vext die Zenerspannung der Zenerdiode Z überschreitet, liegt am Pluseingang des Komparators 32 eine der Zenerspannung entsprechende konstante externe Referenzspannung Vref,ext an. Diese externe Referenzspannung Vref,ext wird verglichen mit einer aus der internen Versorgungsspannung Vcc abgeleiteten und über eine Spannungsteilerschaltung R2, R3 bereitgestellte internen Referenzspannung Vref,int. Der Komparator 32 generiert an seinem Ausgang ein binäres internes Steuersignal S, das vom Vorzeichen der Differenz der externen Referenzspannung Vref,ext und der internen Versorgungsspannung Vcc abhängig ist. Dieses interne Steuersignal S wird auf das Gate eines Mosfet 34 gegeben, dessen DRAIN an den Steuerausgang 20 angeschlossen ist.

Der Mosfet 34 ist im sperrenden Zustand, wenn am Ausgang des Komparators 32 keine Steuerspannung (internes Steuersignal S = low) ansteht. Dies ist immer dann der Fall, wenn der von der externen Spannungsversorgung versorgte Komparator 32 wegen fehlender oder unzureichender externer Versorgungsspannung Vext nicht betriebsbereit oder die interne Referenzspannung Vref,int kleiner als die externe Referenzspannung Vref,ext ist.

Aus dem internen Steuersignal S wird auf diese Weise aus der externen Versorgungsspannung Vext das Ausgangssteuersignal R generiert, das im Ausführungsbeispiel die Werte Null (low) und Vext (high) annimmt. Durch eine geeignete Spannungsleiterschaltung kann der Spannungswert für den Zustand high beliebig zwischen Null und Vext eingestellt werden.

Parallel zum Mosfet 34 ist ein weiterer Mosfet 36 geschaltet, dessen Gate an einen internen Baustein 38 angeschlossen ist, der aus der internen Versorgungsspannung Vcc eine Steuerspannung für das Gate des Mosfet 36 generiert, so dass dieser an Stelle des Mosfet 34 das Ausgangssteuersignal R erzeugen kann.

Um bei fehlender externer Spannungsversorgung die Funktionsfähigkeit des Interface 2 aufrechtzuerhalten, wird in einer solchen Betriebsart der Spannungsausgang 12 mit dem Spannungseingang 20 kurzgeschlossen, wie dies in der Figur durch eine strichpunktiert veranschaulichte Brücke 40 dargestellt ist.

## Patentansprüche

1. Interface (2) zum Ankoppeln eines Busteilnehmers (6) an die Busleitung eines Bussystems (4), mit einem Eingang (10) für eine von einer busunabhängigen Spannungsquelle (8) bereitgestellte externe Versorgungsspannung (Vext) und mit einer Überwachungsschaltung (30) zum Vergleichen einer aus der Busspannung abgeleiteten internen Versorgungsspannung (Vcc) mit der externen Versorgungsspannung (Vext) und zum Generieren eines Ausgangssteuersignals (R) für den Busteilnehmer (6) in Abhängigkeit vom Vergleichsergebnis.

2. Interface (2) nach Anspruch 1, bei dem das Ausgangssteuersignal (R) ein binäres Signal ist, dessen Wert durch das Vorzeichen der Differenz zwischen einer aus der internen Versorgungsspannung (Vcc) und der externen Versorgungsspannung (Vext) jeweils abgeleiteten internen bzw. externen Referenzspannung (Vref,int bzw. Vref,ext) bestimmt ist.

3. Bussystem mit einem Interface (2) nach Anspruch 1 oder 2, und mit einer busunabhängigen Spannungsquelle (8) zur Versorgung zumindest eines Busteilnehmers (6).

4. Bussystem mit einem Interface (2) nach Anspruch 1 oder 2, bei dem bei an einem von der internen Versorgungsspannung (Vcc) versorgten Busteilnehmer (6) der Eingang (10) für die externe Versorgungsspannung (Vext) mit dem Spannungsausgang (12) der internen Versorgungsspannung (Vcc) kurzgeschlossen ist.

## Claims

1. Interface (2) for coupling a bus user (6) to the bus line of a bus system (4), having an input (10) for an external supply voltage (Vext) which is made available by a voltage source (8) which is independent of the bus, and having a monitoring circuit (30) for comparing an internal supply voltage (Vcc) which is derived from the bus voltage with the external supply voltage (Vext), and for generating an output control signal (R) for the bus user (6) as a function of the result of the comparison.

2. Interface (2) according to Claim 1, in which the output control signal (R) is a binary signal whose value is determined by the sign of the difference between an internal reference voltage (Vref,int) and an external reference voltage (Vref,ext), respectively derived from the internal supply voltage (Vcc) and the external supply voltage (Vext).

3. Bus system having an interface (2) according to Claim 1 or 2, and having a voltage source (8) which is independent of the bus, for supplying at least one bus user (6).

4. Bus system having an interface (2) according to Claim 1 or 2, in which in the case of a bus user (6) which is supplied by the internal supply voltage (Vcc), the input (10) for the external supply voltage (Vext) is short-circuited to the voltage output (12) of the internal supply voltage (Vcc).

## Revendications

1. Interface (2) de couplage d'un noeud (6) au bus d'un système de bus (4) comportant une entrée (10) pour une tension d'alimentation externe (Vext) délivrée par une source de tension (8) indépendante du bus et un circuit de surveillance (30) dont la fonction est de comparer une tension d'alimentation interne (Vcc) provenant de la tension de bus avec la tension d'alimentation exteme (Vext) et de générer un signal de commande de sortie (R) pour le noeud (6) en fonction du résultat de la comparaison.

2. Interface (2) selon la revendication 1, dans lequel le signal de commande de sortie (R) est un signal binaire dont la valeur est déterminée par le signe de la différence entre des tensions de référence interne et externe (Vref,in et Vref,ext) provenant respectivement de la tension d'alimentation interne (Vcc) et de la tension d'alimentation externe (Vext).

3. Système de bus comportant une interface (2) selon la revendication 1 ou 2, et comportant une source de tension (8) indépendante du bus pour alimenter au moins un noeud (6).

4. Système de bus comportant une interface (2) selon la revendication 1 ou 2, dans lequel l'entrée (10) pour la tension d'alimentation externe (Vext) est court-circuitée avec la sortie (12) pour la tension d'alimentation interne (Vcc) lorsqu'un noeud (6) est alimenté par la tension d'alimentation interne (Vcc).
